# EUROPEAN PATENT APPLICATION

(11) **EP 3 862 159 A1**
(43) Date of publication of application: **11.08.2021**
(21) Application number: 19869137.0
(22) Date of filing: 01.10.2019
(51) Int. Cl.: B29C 33/68, C08J 5/18, H01L 21/60, H01L 21/603

(54) **HEAT-RESISTANT RELEASE SHEET AND THERMOCOMPRESSION BONDING METHOD**

(30) Priority: 04.10.2018 JP 2018189071
(71) Applicant: NITTO DENKO CORPORATION, Ibaraki-shi Osaka 567-8680 (JP)
(72) Inventor: AKIBA, Kurato, Ibaraki-shi, Osaka 567-8680 (JP); YOSHIMATSU, Kimihiko, Ibaraki-shi, Osaka 567-8680 (JP)
(74) Representative: Müller-Boré & Partner Patentanwälte PartG mbB
(86) International application number: PCT/JP2019/038804
(87) International publication number: WO 2020/071388

(57) **Abstract**

A heat-resistant release sheet of the present disclosure includes a heat-resistant release sheet to be disposed between a compression bonding target and a thermocompression head at the time of thermocompression-bonding the compression bonding target by the thermocompression head to prevent fixation between the compression bonding target and the thermocompression head, wherein surface hardness, as expressed in an indentation degree A₃₀₀ given by an equation A₃₀₀ (%) = (d_{300/}t₀) × 100, of the heat-resistant release sheet at 300°C is 15% or less, where t₀ is a thickness of the heat-resistant release sheet at ordinary temperature (20°C) and d₃₀₀ is an indentation depth evaluated for the heat-resistant release sheet at 300°C using a penetration probe by thermomechanical analysis (TMA) under the following measurement conditions: [Measurement conditions] • Measurement mode: penetration mode, temperature rise measurement • Shape and tip diameter of penetration probe: columnar shape and 1 mmϕ • Applied pressure: 1 MPa • Starting temperature and temperature increase rate: 20°C and 10°C/min. The heat-resistant release sheet of the present disclosure can more reliably adapt to an expected further increase in thermocompression bonding temperature.

## Description

### TECHNICAL FIELD

The present invention relates to a heat-resistant release sheet and a thermocompression bonding method using the same.

### BACKGROUND ART

Thermocompression bonding is used for manufacturing and flip chip mounting of semiconductor chips using an underfill such as a non-conductive film (NCF) and a non-conductive paste (NCP) and for manufacturing of printed circuit boards (PCBs). Thermocompression bonding is also used, for example, for bonding of an electronic part to a PCB by using an anisotropic conductive film (ACF). A thermocompression head, which is a heat source as well as a pressure source, is generally used to thermocompression-bond a compression bonding target. In order to prevent fixation between the compression bonding target and the thermocompression head at the time of thermocompression bonding, a heat-resistant release sheet is commonly disposed between the compression bonding target and the thermocompression head.

In Patent Literature 1 is disclosed, though not a heat-resistant release sheet itself, a tetrafluoroethylene-hexafluoropropylene copolymer (FEP) film used to shape a curved plane with fiber-reinforced prepreg.

### CITATION LIST

### Patent Literature

Patent Literature 1: JP 2002-321238 A

### SUMMARY OF INVENTION

### Technical Problem

A further increase in thermocompression bonding temperature at the time of thermocompression-bonding a compression bonding target is expected. The further increase in thermocompression bonding temperature makes it possible, for example, to thermocompression-bond a compression bonding target in which more layers than ever are laminated and to improve manufacturing efficiency and mounting efficiency of semiconductor chips.

The present invention is intended to provide a heat-resistant release sheet that is disposed between a compression bonding target and a thermocompressing head at the time of thermocompression-bonding the compression bonding target by the thermocompressing head to prevent fixation between the compression bonding target and the thermocompressing head, and that can more reliably adapt to the expected further increase in thermocompression bonding temperature.

### Solution to Problem

The present invention provides a heat-resistant release sheet to be disposed between a compression bonding target and a thermocompression head at the time of thermocompression-bonding the compression bonding target by the thermocompression head to prevent fixation between the compression bonding target and the thermocompression head, wherein
surface hardness, as expressed in an indentation degree A₃₀₀ given by an equation A₃₀₀ (%) = (d₃₀₀/t₀) × 100, at 300°C is 15% or less, where t₀ is a thickness of the heat-resistant release sheet at ordinary temperature (20°C) and d₃₀₀ is an indentation depth evaluated for the heat-resistant release sheet at 300°C using a penetration probe by thermomechanical analysis (hereinafter referred to as "TMA") under the following measurement conditions:

### [Measurement conditions]

- Measurement mode: penetration mode, temperature rise measurement
- Shape and tip diameter of penetration probe: columnar shape and 1 mmϕ
- Applied pressure: 1 MPa
- Starting temperature and temperature increase rate: 20°C and 10°C/min

In another aspect, the present invention provides a method for thermocompression-bonding a compression bonding target by a thermocompression head, the method including thermocompression-bonding the compression bonding target by the thermocompression head with a heat-resistant release sheet disposed between the thermocompression head and the compression bonding target, wherein
the heat-resistant release sheet is the above heat-resistant release sheet of the present invention.

### Advantageous Effects of Invention

The surface hardness of the heat-resistant release sheet of the present invention at 300°C is in the specific range. Because of this, when the thermocompression bonding temperature is further increased, for example, when the heating temperature of a thermocompressing head is increased to around 330°C, the heat-resistant release sheet is unlikely to adhere to the surface of the thermocompressing head and can maintain a high releasability as the heat-resistant release sheet. Even when partial adhesion occurs between the heat-resistant release sheet fed by conveyance and a thermocompressing head, the heat-resistant release sheet can be prevented from undergoing surface elongation to follow the thermocompressing head and a high releasability can be ensured. Therefore, the heat-resistant release sheet of the present invention can more reliably adapt to the expected further increase in thermocompression bonding temperature.

### BRIEF DESCRIPTION OF DRAWINGS

FIG. 1 is a cross-sectional view that schematically shows an example of the heat-resistant release sheet of the present invention.
FIG. 2 is a schematic diagram for illustrating an example of a thermocompression bonding method using the heat-resistant release sheet of the present invention.

### DESCRIPTION OF EMBODIMENTS

Hereinafter, embodiments of the present invention will be described with reference to the drawings.

### [Heat-resistant release sheet]

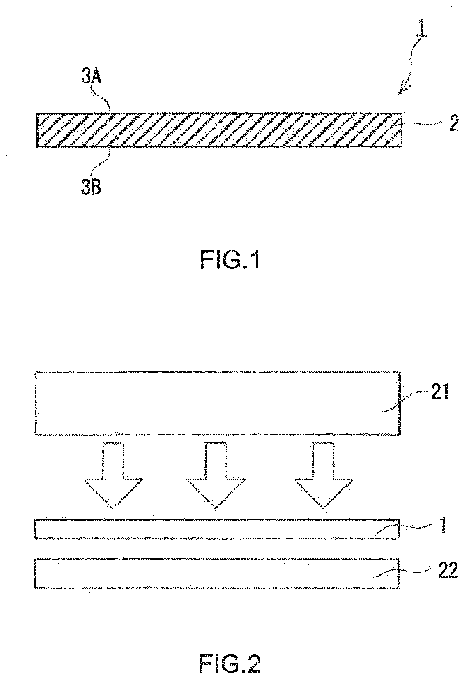

FIG. 1 shows an example of the heat-resistant release sheet of the present invention. A heat-resistant release sheet 1 shown in FIG. 1 is formed of a polytetrafluoroethylene (hereinafter referred to as "PTFE") sheet 2. The heat-resistant release sheet 1 of FIG. 1 has a single-layer structure consisting of the PTFE sheet 2. The heat-resistant release sheet 1 has high heat resistance and high releasability derived from PTFE included in the sheet 2.

Surface hardness, as expressed in an indentation degree A₃₀₀ given by an equation A₃₀₀ (%) = (d₃₀₀/t₀) × 100, of the heat-resistant release sheet 1 at 300°C is 15% or less. In the equation, t₀ is a thickness of the heat-resistant release sheet 1 at ordinary temperature (20°C). d₃₀₀ is an indentation depth evaluated for the heat-resistant release sheet 1 at 300°C using a penetration probe by TMA under the following measurement conditions:

### [Measurement conditions]

- Measurement mode: penetration mode, temperature rise measurement
- Shape and tip diameter of penetration probe: columnar shape and 1 mmϕ
- Applied pressure: 1 MPa
- Starting temperature and temperature increase rate: 20°C and 10°C/min

The indentation degree A₃₀₀ may be 14.5% or less, 14% or less, 13.5% or less, 13% or less, 12.5% or less, 12% or less, 11.5% or less, 11% or less, 10.5% or less, 10% or less, 9.5% or less, 9% or less, 8.5% or less, 8% or less, 7.5% or less, 7% or less, 6.5% or less, 5% or less, 4.5% or less, or even 4% or less. The lower limit of the indentation degree A₃₀₀ is, for example, -5% or more, and may be -4% or more, -3% or more, -2% or more, or even -1% or more. The indentation degree A₃₀₀ can be a negative value due to heat expansion of the heat-resistant release sheet 1.

The heat-resistant release sheet 1 of FIG. 1 is formed of the PTFE sheet 2. However, a resin included in the heat-resistant release sheet 1 of the present invention is not limited to PTFE as long as the surface hardness, as expressed in the indentation degree A₃₀₀, at 300°C is 15% or less. In consideration of the heat resistance of the heat-resistant release sheet 1, the resin included in the heat-resistant release sheet 1 preferably has a melting point of 310°C or higher and/or a glass transition temperature of 210°C or higher. The melting point may be more than 310°C, 315°C or higher, 320°C or higher, or even 325°C or higher. The upper limit of the melting point is, for example, 400°C or less. The glass transition temperature may be 220°C or higher, 230°C or higher, 240°C or higher, or even 250°C or higher. The glass transition temperature is, for example, 300°C or less. In the present specification, the melting point of a resin refers to the peak temperature at an "endothermic peak attributed to crystal melting," the endothermic peak being measured by differential scanning calorimetry (hereinafter referred to as "DSC") in which the temperature of the resin is increased at a constant temperature rise rate, e.g., 10°C/min. In the present specification, the glass transition temperature of a resin refers to the peak temperature at an "endothermic peak attributed to a glass transition," the endothermic peak being measured by DSC in which the temperature of the resin is increased at a constant temperature rise rate, e.g., 10°C/min.

The resin that can be included in the heat-resistant release sheet 1 of the present invention is, for example, at least one selected from PTFE, a modified PTFE, polyimide, polyamideimide, and polyetheretherketone (PEEK), and may be at least one selected from PTFE, a modified PTFE, polyamideimide, and PEEK or may be PTFE and/or a modified PTFE. The heat-resistant release sheet 1 may include a PTFE sheet, a modified PTFE sheet, a polyimide sheet, a polyamideimide sheet, or a PEEK sheet, may include a PTFE sheet, a modified PTFE sheet, a polyamideimide sheet, or a PEEK sheet, or may include a PTFE sheet or a modified PTFE sheet.

The modified PTFE is a copolymer of TFE and a modified comonomer. The content of a tetrafluoroethylene (TFE) unit in the copolymer needs to be 99 mass% or more so that the copolymer can be classified as the modified PTFE. The modified PTFE is, for example, a copolymer of TFE and at least one modified comonomer selected from ethylene, perfluoroalkylvinyl ether, and hexafluoropropylene.

At least one principal surface (a principal surface 3A and/or a principal surface 3B) of the heat-resistant release sheet 1 may be subjected to a modification treatment for increasing the surface hardness of the principal surface, in other words, a modification treatment for decreasing the indentation degree A₃₀₀. The heat-resistant release sheet 1 subjected to the modification treatment can more reliably adapt to a further increase in thermocompression bonding temperature. The modification treatment is preferably a treatment in which a new layer and/or coating formed of a resin and/or compound different from those included in the heat-resistant release sheet are not formed on the at least one principal surface. An example of the treatment is a treatment for modifying the at least one principal surface. By the treatment, for example, the heat conductivity of the heat-resistant release sheet 1 can be maintained. Moreover, a thermocompressing head and/or a compression bonding target can be prevented from being contaminated by a decomposition product resulting from high temperature-induced decomposition of the new layer and/or coating at the time of thermocompression bonding.

In thermocompression bonding by a thermocompressing head, a principal surface of the heat-resistant release sheet 1, the principal surface being brought into contact with the thermocompressing head, is exposed to a higher temperature than the principal surface brought into contact with a compression bonding target. Therefore, the heat-resistant release sheet 1 having one principal surface having been subjected to the above modification treatment is preferably used such that the one principal surface is brought into contact with a thermocompressing head.

When the heat-resistant release sheet 1 includes a PTFE sheet or a modified PTFE sheet, the modification treatment is, for example, a chemical treatment of the one principal surface. Examples of the chemical treatment include a metallic sodium treatment. The modification treatment is not limited to this example. In the metallic sodium treatment of the PTFE sheet and the modified PTFE sheet, abstraction of a fluorine atom and carbonization proceed on a treatment surface of the sheet. It is inferred that the abstraction and carbonization improves the surface hardness of the treatment surface. The metallic sodium treatment can be performed, for example, by applying a treatment liquid containing metallic sodium to the at least one principal surface of the PTFE sheet or the modified PTFE sheet to be treated, or by immersing the PTFE sheet or the modified PTFE sheet to be treated in the treatment liquid. By the immersion method, both principal surfaces of the PTFE sheet or the modified PTFE sheet can be subjected to the modification treatment.

Examples of the treatment liquid used in the metallic sodium treatment include an ammonia solution of metallic sodium and a tetrahydrofuran solution of a metallic sodium-naphthalene complex. A commercially-available treatment liquid (e.g., FluoroBonder (registered trademark) manufactured by Technos Corporation) may be used as the treatment liquid.

The metallic sodium treatment of a PTFE sheet has been known to improve the ability of the PTFE sheet to allow adhesion to a treatment surface thereof. The improving effect of the metallic sodium treatment on the releasability of a PTFE sheet subjected to the metallic sodium treatment and used as a heat-resistant release sheet particularly at a further increased thermocompression bonding temperature is found for the first time by the present inventors.

The PTFE sheet 2 is preferably a sintered PTFE sheet including PTFE having been sintered. In the present specification, sintering of PTFE means heating PTFE obtained by polymerization to a temperature equal to or higher than its melting point (327°C), for example, to 340 to 380°C.

The heat-resistant release sheet 1 has a thickness of, for example, 1 to 50 µm, and may have a thickness of 5 to 40 µm, 10 to 35 µm, 20 to 35 µm, or even 25 to 35 pm.

The heat-resistant release sheet 1 has a tensile strength of, for example, 30 MPa or more, though the tensile strength varies depending on the type of the resin included in the heat-resistant release sheet 1. The heat-resistant release sheet 1 may have a tensile strength of 33 MPa or more, 35 MPa or more, 40 MPa or more, 45 MPa or more, 50 MPa or more, 55 MPa or more, 60 MPa or more, 80 MPa or more, 100 MPa or more, 150 MPa or more, 200 MPa or more, 220 MPa or more, 240 MPa or more, or even 260 MPa or more. The upper limit of the tensile strength is, for example, 500 MPa or less. The heat-resistant release sheet 1 having a tensile strength in these ranges can be more reliably fed between a thermocompressing head and a compression bonding target by conveyance.

The heat-resistant release sheet 1 has a maximum tensile elongation of, for example, 380% or less, though the maximum tensile elongation varies depending on the type of the resin included in the heat-resistant release sheet 1. The heat-resistant release sheet 1 may have a maximum tensile elongation of 360% or less, 340% or less, 300% or less, 280% or less, 250% or less, 200% or less, 180% or less, 150% or less, 130% or less, 120% or less, 100% or less, 50% or less, 40% or less, or even 35% or less. The lower limit of the maximum tensile elongation is, for example, 5% or more. By virtue of the heat-resistant release sheet 1 having a maximum tensile elongation in these ranges, particularly the heat-resistant release sheet 1 having a maximum tensile elongation of 300% or less, when the heat-resistant release sheet 1 partially adheres to a thermocompression head and/or a compression bonding target at the time of feeding the sheet 1 between the thermocompression head and the compression bonding target by conveyance, the sheet 1 can be prevented from elongating to follow these members. In other words, the releasability of the heat-resistant release sheet 1 from a thermocompression head and/or a compression bonding target can further be improved.

The tensile strength and the maximum tensile elongation of the heat-resistant release sheet 1 can be determined by a tensile test using a tensile testing machine. In the tensile test, the tensile direction is, for example, the longitudinal direction (MD direction) of the heat-resistant release sheet 1. A specimen has, for example, the shape of a No. 1 dumbbell defined in Japanese Industrial Standards (JIS) K 6251: 1993. When the above specimen is used, the measurement conditions are, for example, such that the test length of a dumbbell of the specimen is 40 mm, the chuck-to-chuck distance is 70 mm, and the tensile rate is 200 mm/min. The maximum tensile elongation can be calculated from the above pre-test (original) test length of a dumbbell and the test length of a dumbbell at break. The measurement temperature is, for example, 25 ± 10°C.

In the heat-resistant release sheet 1, another layer may be disposed on the principal surface 3A and/or the principal surface 3B. However, in order to ensure a good heat conductivity of the heat-resistant release sheet 1, it is preferred that no other layer be disposed on the principal surfaces of the heat-resistant release sheet 1. In other words, the heat-resistant release sheet 1 preferably consists of a single layer.

The heat-resistant release sheet 1 is preferably a non-porous sheet. The heat-resistant release sheet 1 may be an impermeable sheet that allows no fluid, such as water, to permeate therethrough in the thickness direction because of high liquid repellency (water repellency and oil repellency) of the material, such as PTFE, included in the sheet 1. The heat-resistant release sheet 1 may be an insulating sheet (a nonconductive sheet) because of high insulating properties of the material, such as PTFE, included in the sheet 1.

The heat-resistant release sheet 1 is in the shape of, for example, a polygon such as a square or a rectangle, a circle, an oval, or a strip. The polygon may have a rounded corner. The shape of the heat-resistant release sheet 1 is, however, not limited to these examples. The polygonal-shaped, circular-shaped, or oval-shaped heat-resistant release sheet 1 can be distributed in the form of a sheet, and the strip-shaped heat-resistant release sheet 1 can be distributed in the form of a winding body (roll) formed of the sheet 1 wound around a winding core. The width of the strip-shaped heat-resistant release sheet 1 and that of the winding body formed of the strip-shaped wound heat-resistant release sheet 1 can be set to any values.

### [Method for manufacturing heat-resistant release sheet]

Exemplary methods for manufacturing the heat-resistant release sheet 1 will be described hereinafter using as an example the heat-resistant release sheet 1 formed of the PTFE sheet 2 or a modified PTFE sheet. The method for manufacturing the heat-resistant release sheet 1 is not limited to the following examples.

First, a PTFE powder (molding powder) is charged into a mold, and a given pressure is applied to the powder in the mold for a given period of time to preform the powder. The preforming can be performed at ordinary temperature. The internal space of the mold preferably has a columnar shape so that the below-described cutting using a cutting lathe can be performed. In that case, a columnar preform and a columnar PTFE block can be obtained. Next, the resulting preform is taken out of the mold and sintered at a temperature equal to or higher than the melting point (327°C) of PTFE for a given period of time to obtain a PTFE block. Subsequently, the obtained PTFE block is cut to a given thickness to obtain the PTFE sheet 2 that is a cut sheet (skived sheet). The obtained PTFE sheet 2 may be directly used as the heat-resistant release sheet 1, or may be used as the heat-resistant release sheet 1, for example, after a given treatment or after another layer is laminated thereon. Examples of the treatment include a modification treatment for increasing the above surface hardness. Examples of the modification treatment include a metallic sodium treatment. The PTFE sheet 2 may be stretched and/or calendered in order to increase the tensile strength of the heat-resistant release sheet 1 or reduce the maximum tensile elongation of the heat-resistant release sheet 1. When the PTFE block has a columnar shape, a cutting lathe, which continuously rotates the block and cuts a surface thereof, can be used and the PTFE sheet 2 and the heat-resistant release sheet 1 can be efficiently formed. Moreover, by means of a cutting lathe, the thicknesses of the PTFE sheet 2 and the heat-resistant release sheet 1 are relatively easily controlled and the PTFE sheet 2 and the heat-resistant release sheet 1 can be formed in the shape of a strip, too. Furthermore, a modified PTFE sheet can be formed by the above method with the use of a modified PTFE powder instead of the PTFE powder.

The heat-resistant release sheet 1 may be manufactured by the following method.

First, a substrate sheet having a surface to which a PTFE dispersion is to be applied is prepared. The substrate sheet is formed of, for example, a resin, a metal, paper, or a composite material thereof. The surface of the substrate sheet to which the PTFE dispersion is to be applied may have been subjected to a separation treatment for easier separation of the PTFE sheet 2 from the substrate sheet. Any of known methods may be employed for the separation treatment. Next, a coating film of the PTFE dispersion is formed on the surface of the substrate sheet. Any of various coaters can be used for the application of the PTFE dispersion. The PTFE dispersion may be applied to the surface of the substrate sheet by immersing the substrate sheet in the PTFE dispersion. Next, a PTFE sheet is formed by drying and sintering the coating film formed of the PTFE dispersion on the surface of the substrate sheet. Then, the formed PTFE sheet is separated from the substrate sheet to obtain the PTFE sheet 2 that is a cast sheet. The obtained PTFE sheet 2 may be directly used as the heat-resistant release sheet 1, or may be used as the heat-resistant release sheet 1, for example, after a given treatment or after another layer is laminated thereon. Examples of the treatment include those described above. The PTTFE sheet 2 may be stretched and/or calendered in order to increase the tensile strength of the heat-resistant release sheet 1 or reduce the maximum tensile elongation of the heat-resistant release sheet 1. The thicknesses of the PTFE sheet 2 and the heat-resistant release sheet 1 formed by this method can be controlled by adjusting the thickness of the PTFE dispersion applied to the substrate sheet and/or the number of times the PTFE dispersion is applied thereto. Additionally, a modified PTFE sheet can be formed by the above method with the use of a modified PTFE dispersion instead of the PTFE dispersion.

### [Use of heat-resistant release sheet]

As shown in FIG. 2, the heat-resistant release sheet 1 can be used as a heat-resistant release sheet disposed between a thermocompression head 21 and a compression bonding target 22 at the time of thermocompression-bonding the compression bonding target 22 by the thermocompression head 21 to prevent fixation between the thermocompression head 21 and the compression bonding target 22. The heat-resistant release sheet 1 has high releasability. It is possible to prevent fixation (heat fixation) of the heat-resistant release sheet 1 to the thermocompression head 21 and/or the compression bonding target 22, the fixation being caused by heat generated for thermocompression bonding.

The heat-resistant release sheet 1 may be fed and disposed between the thermocompression head 21 and the compression bonding target 22 by conveyance. The heat-resistant release sheet 1 fed and disposed by conveyance is, for example, in the shape of a strip.

Examples of the compression bonding target 22 include a semiconductor chip, a PCB, and an electronic part. The heat-resistant release sheet 1 can be used, for example, for manufacturing and flip chip mounting of semiconductor chips, manufacturing of PCBs, and bonding of electronic parts by thermocompression bonding.

The heating temperature of the thermocompressing head 21 at the time of thermocompression bonding, i.e., the use temperature of the heat-resistant release sheet 1, can be, for example, 300°C or higher. The use temperature may be 310°C or higher, 320°C or higher, 330°C or higher, or even 340°C or higher. It should be noted that the use temperature of the heat-resistant release sheet 1 is not limited to these ranges. The heat-resistant release sheet 1 can be used at a use temperature lower than the above examples.

### [Thermocompression bonding method]

The compression bonding target 22 can be thermocompression-bonded using the heat-resistant release sheet 1 of the present invention. The thermocompression bonding method is a method for thermocompression-bonding the compression bonding target 22 by the thermocompression head 21. The thermocompression bonding method includes thermocompression-bonding the compression bonding target 22 by the thermocompression head 21 with the heat-resistant release sheet 1 disposed between the thermocompression head 21 and the compression bonding target 22. The heat-resistant release sheet 1 can be fed and disposed between the thermocompression head 21 and the compression bonding target 22, for example, by conveyance.

### [Method for manufacturing thermocompression bonded article]

A thermocompression bonded article can be manufactured using the heat-resistant release sheet 1 of the present invention. The method for manufacturing the thermocompression bonded article includes a step of thermocompression-bonding the compression bonding target 22 using the thermocompression head 21 with the heat-resistant release sheet 1 disposed between the thermocompression head 21 and the compression bonding target 22 to obtain a thermocompression bonded article which is a thermocompression bonded body of the compression bonding target 22. Examples of the thermocompression bonded article include a PCB and an electronic parts.

### EXAMPLES

Hereinafter, the present invention is described in more detail with reference to examples. The present invention is not limited to the following examples.

First, the methods for evaluating heat-resistant release sheets produced in examples will be described.

### [Surface hardness (indentation degree A₃₀₀)]

The indentation degree A₃₀₀ was evaluated by the above method as the surface hardness at 300°C. The details will be described hereinafter. First, each heat-resistant release sheet to be evaluated was cut into a 7mm × 7mm square to obtain a specimen. Next, the thickness of the specimen was measured as the thickness t₀ using a micrometer (manufactured by Mitutoyo Corporation). Subsequently, the specimen was placed on an evaluation stage of a TMA apparatus (TMA4000S manufactured by Bruker Corporation). Using a columnar penetration probe having a diameter of 1 mm, the indentation depth d₃₀₀ by the penetration probe was measured for the specimen at 300°C. The measurement mode was penetration mode and temperature rise measurement. The pressure applied to the specimen was a constant pressure of 1 MPa, the starting temperature was 20°C, and the temperature rise rate was 10°C/min. From the measured thickness to and indentation depth d₃₀₀, the indentation degree A₃₀₀ was determined by the equation A₃₀₀ (%) = (d₃₀₀/t₀) × 100.

### [Releasability at the time of thermocompression bonding]

The releasability (the releasability from a thermocompressing head) at the time of thermocompression bonding was evaluated as follows.

Each heat-resistant release sheet to be evaluated was cut into a rectangle having a size of 20 mm × 100 mm and disposed on a stage of a thermocompression bonding apparatus (a flip chip bonder FC3000W manufactured by Toray Engineering Co., Ltd.) equipped with a thermocompression head and the stage. The heat-resistant release sheet was stuck and fixed to the stage using an adhesive tape (No. 360UL manufactured by NITTO DENKO CORPORATION and having a polyimide substrate; thickness: 60 pm; width: 19 mm) having a heat resistance high enough to endure a thermocompression bonding test. Specifically, the above adhesive tape was applied to each of the short sides of the heat-resistant release sheet placed on the stage to secure the short sides in such a manner that each piece of the adhesive tape had an adhesion width of 10 mm on the heat-resistant release sheet and 9 mm on the stage. Each piece of the adhesive tape used had a length of 50 mm. A longitudinally middle portion of each piece of the adhesive tape was brought into contact with the heat-resistant release sheet. The set temperature of the stage was 120°C. Next, after the thermocompression head was lowered so as to reach a compression pressure of 20 N, the temperature of the head was increased to 330°C and a thermocompression bonding test was performed for a compression time of 10 seconds to evaluate whether heat fixation of the heat-resistant release sheet to the thermocompression head occurred. The releasability was judged as good (o) when the pieces of the adhesive tape were not removed from the stage and the heat-resistant release sheet was separated from the thermocompressing head by lifting the thermocompressing head after the thermocompression bonding test. The releasability was judged as poor (×) when the heat-resistant release sheet was not separated by lifting the thermocompressing head after the thermocompression bonding test or when the heat-resistant release sheet was separated but at least a part of the adhesive tapes was removed from the stage by lifting the thermocompressing head after the thermocompression bonding test.

### [Tensile strength and maximum tensile elongation]

The tensile strength (tensile strength at break) and the maximum tensile elongation were determined by a tensile test using a tensile testing machine (AG-I manufactured by Shimadzu Corporation). The tensile direction was the longitudinal direction (MD direction) of the heat-resistant release sheets. Specimens had the shape of a No. 1 dumbbell defined in JIS K 6251: 1993. The measurement conditions were such that the measurement temperature was 25°C, the test length of the dumbbell of the specimen was 40 mm, the chuck-to-chuck distance was 70 mm, and the tensile rate was 200 mm/min. The maximum tensile elongation was calculated from the above pre-test (original) test length of the dumbbell and the test length of the dumbbell at break.

### (Example 1)

A PTFE powder (POLYFLON PTFE M-18 manufactured by DAIKIN INDUSTRIES, LTD.) was charged into a cylindrical mold and preformed at a temperature of 23°C and a pressure of 8.5 MPa for a pressure application time of 1 hour. Next, the resulting preform was taken out of the mold and sintered at 370°C for 24 hours to obtain a columnar PTFE block having a height of 300 mm and an outer diameter of 470 mm. Then, the obtained PTFE block was cut using a cutting lathe to obtain a 50-µm-thick PTFE sheet. Next, the obtained cut film was calendered using a roll calendering machine equipped with a pair of metal rolls maintained at 170°C to obtain a heat-resistant release sheet of Example 1 that is a 30-µm-thick PTFE sheet. The heat-resistant release sheet of Example 1 had an indentation degree A₃₀₀ of 0.3%, a tensile strength of 66.2 MPa, and a maximum tensile elongation of 120%, and the result of releasability evaluation was "good" (o). The melting point of the PTFE forming the heat-resistant release sheet of Example 1 was 327°C or higher.

### (Example 2)

A heat-resistant release sheet as produced in Example 1 was immersed in a treatment liquid (FluoroBonder (registered trademark) manufactured by Technos Corporation) containing metallic sodium, pulled out, and washed with acetone. Next, the sheet was immersed in pure water, washed, and then dried at 100°C for 1 minute to obtain a heat-resistant release sheet of Example 2 both of whose principal surfaces had been subjected to a metallic sodium treatment. The time of immersion in the treatment liquid was 30 seconds. The heat-resistant release sheet of Example 2 had an indentation degree A₃₀₀ of 0.1%, a tensile strength of 59.9 MPa, and a maximum tensile elongation of 118%, and the result of releasability evaluation was "good" (○). The melting point of the PTFE forming the heat-resistant release sheet of Example 2 was 327°C or higher.

### (Example 3)

A PTFE block as produced in Example 1 was cut using a cutting lathe to obtain a 30-µm-thick skived PTFE film. This was employed as a heat-resistant release sheet of Example 3. The heat-resistant release sheet of Example 3 had an indentation degree A₃₀₀ of 11%, a tensile strength of 34.6 MPa, and a maximum tensile elongation of 177%, and the result of releasability evaluation was "good" (o). The melting point of the PTFE forming the heat-resistant release sheet of Example 3 was 327°C or higher.

### (Example 4)

A heat-resistant release sheet as produced in Example 3 was subjected to the same metallic sodium treatment as that in Example 2. The treated sheet was employed as a heat-resistant release sheet of Example 4. The heat-resistant release sheet of Example 4 had an indentation degree A₃₀₀ of 0.1%, a tensile strength of 33.1 MPa, and a maximum tensile elongation of 180%, and the result of releasability evaluation was "good" (○). The melting point of the PTFE forming the heat-resistant release sheet of Example 4 was 327°C or higher.

### (Example 5)

A modified PTFE block was obtained in the same manner as in Example 1, except that a modified PTFE powder (Dyneon TFM, modified PTFE, TFM 1700 manufactured by 3M Company; content of TFE unit: 99 mass% or more) was used instead of the PTFE powder. The obtained modified PTFE block was cut using a cutting lathe to obtain a 30-µm-thick cut modified PTFE film. This was employed as a heat-resistant release sheet of Example 5. The heat-resistant release sheet of Example 5 had an indentation degree A₃₀₀ of 10%, a tensile strength of 42.1 MPa, and a maximum tensile elongation of 278%, and the result of releasability evaluation was "good" (○). The melting point of the modified PTFE forming the heat-resistant release sheet of Example 5 was 327°C or higher.

### (Example 6)

A heat-resistant release sheet as produced in Example 5 was subjected to the same metallic sodium treatment as that in Example 2. The treated sheet was employed as a heat-resistant release sheet of Example 6. The heat-resistant release sheet of Example 6 had an indentation degree A₃₀₀ of 0.2%, a tensile strength of 43.1 MPa, and a maximum tensile elongation of 270%, and the result of releasability evaluation was "good" (○). The melting point of the PTFE forming the heat-resistant release sheet of Example 6 was 327°C or higher.

The evaluation results are collectively shown in Table 1 below.

**[Table 1]**

| | Example 1 | Example 2 | Example 3 | Example 4 | Example 5 | Example 6 |
|---|---|---|---|---|---|---|
| Surface hardness (indentation degree A₃₀₀) (%) | 0.3 | 0.1 | 11 | 0.1 | 10 | 0.2 |
| Tensile strength (MPa) | 66.2 | 59.9 | 34.6 | 33.1 | 42.1 | 43.1 |
| Maximum tensile elongation (%) | 120 | 118 | 177 | 180 | 278 | 270 |
| Releasability | ○ | ○ | ○ | ○ | ○ | ○ |

### INDUSTRIAL APPLICABILITY

The heat-resistant release sheet of the present invention can be used to prevent fixation between a thermocompression head and a compression bonding target by disposing the sheet between the thermocompression head and the compression bonding target at the time of thermocompression-bonding the compression bonding target by the thermocompression head. Thermocompression bonding using the heat-resistant release sheet of the present invention is applicable, for example, to manufacturing and flip chip mounting of semiconductor chips, manufacturing of PCBs, and bonding of electronic parts.

## Claims

1. A heat-resistant release sheet to be disposed between a compression bonding target and a thermocompression head at the time of thermocompression-bonding the compression bonding target by the thermocompression head to prevent fixation between the compression bonding target and the thermocompression head, wherein
surface hardness, as expressed in an indentation degree A₃₀₀ given by an equation A₃₀₀ (%) = (d₃₀₀/t₀) × 100, at 300°C is 15% or less, where t₀ is a thickness of the heat-resistant release sheet at ordinary temperature (20°C) and d₃₀₀ is an indentation depth evaluated for the heat-resistant release sheet at 300°C using a penetration probe by thermomechanical analysis (TMA) under the following measurement conditions:
[Measurement conditions]
• Measurement mode: penetration mode, temperature rise measurement
• Shape and tip diameter of penetration probe: columnar shape and 1 mmϕ
• Applied pressure: 1 MPa
• Starting temperature and temperature increase rate: 20°C and 10°C/min

2. The heat-resistant release sheet according to claim 1, comprising a sheet made of polytetrafluoroethylene (PTFE) or a modified PTFE, wherein
the content of a tetrafluoroethylene (TFE) unit in the modified PTFE is 99 mass% or more.

3. The heat-resistant release sheet according to claim 1 or 2, wherein at least one principal surface of the heat-resistant release sheet is subjected to a modification treatment for increasing the surface hardness.

4. The heat-resistant release sheet according to any one of claims 1 to 3, wherein a resin comprised in the heat-resistant release sheet has a melting point of 310°C or higher and/or a glass transition temperature of 210°C or higher.

5. A method for thermocompression-bonding a compression bonding target by a thermocompression head, the method comprising thermocompression-bonding the compression bonding target by the thermocompression head with a heat-resistant release sheet disposed between the thermocompression head and the compression bonding target, wherein
the heat-resistant release sheet is the heat-resistant release sheet according to any one of claims 1 to 4.
